(19) Europäisches Patentamt
European Patent Office
Office européen des brevets

(11) EP 4 772 941 A1

(12) EUROPEAN PATENT APPLICATION

(43) Date of publication:
08.07.2026 Bulletin 2026/28

(21) Application number: 25150508.7

(22) Date of filing: 07.01.2025

(51) International Patent Classification (IPC):
G03F 7/00 (2006.01)    G01N 21/956 (2006.01)

(52) Cooperative Patent Classification (CPC):
G01N 21/956; G03F 7/70616; G03F 7/706831;
G03F 7/706833

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: ASML Netherlands B.V.
5500 AH Veldhoven (NL)

(72) Inventors:
• NIENHUYS, Han-Kwang
  5500 AH Veldhoven (NL)
• BANINE, Vadim, Yevgenyevich
  5500 AH Veldhoven (NL)

(74) Representative: ASML Netherlands B.V.
Corporate Intellectual Property
P.O. Box 324
5500 AH Veldhoven (NL)

(54) **METROLOGY METHOD AND METROLOGY APPARATUS**

(57) Disclosed is a method of metrology comprising: illuminating a periodic structure with measurement illumination, the periodic structure comprising a pitch greater than 17 nm and detecting resultant scattered radiation comprising a plurality of diffraction orders. The measurement illumination comprises an illumination profile configured to either: substantially prevent overlap of the diffraction orders while providing a plurality of angles of incidence on the periodic structure which span a range greater than 10 degrees in at least one direction; or impose discontinuities in a measurement signal described by the scattered radiation as represented in pupil space, the discontinuities enabling the diffraction orders to be distinguished at least at respective locations in the pupil space of a plurality of illumination edges of the illumination profile.

Fig. 10

EP 4 772 941 A1

**Description**

<u>FIELD</u>

The present invention relates to methods of metrology, and in particular methods of metrology usable in lithographic manufacturing methods and processes.

<u>BACKGROUND</u>

In semiconductor device manufacturing processes, apparatuses can be used to process and/or assess objects such as a semiconductor substrate or a patterning device. An example of such an apparatus is an exposure apparatus used to generate interactions between a radiation, for example an electromagnetic radiation or a charged-particle radiation, with a substrate. Other examples of such apparatuses are a deposition apparatus, an etching apparatus, and a die-bonding apparatus. A lithographic apparatus and an assessment apparatus are examples of an exposure apparatus. A lithographic apparatus may use an electromagnetic radiation or a charged-particle radiation to form a pattern onto a layer of radiation-sensitive material, for example a layer of photo resist, provided on a substrate. Examples of a lithographic apparatus are a deep ultraviolet (DUV) lithographic apparatus and an extreme ultraviolet (EUV) lithographic apparatus. An assessment apparatus may form interaction products resulted from interaction of an electromagnetic radiation or charged-particle radiation with a sample such as a substrate. An inspection apparatus and a metrology apparatus are examples of such assessment apparatuses and may be used to detect particles or measure a critical dimension, for example.

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low $k_1$.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

In a metrology tool, it may be desirable to measure targets with relatively large pitches. However, measuring large pitches makes it more difficult (for a given wavelength of measurement radiation) to separate and/or distinguish between diffraction orders on a detector.

It would be desirable to improve measurement of such relatively larger pitches.

## SUMMARY

In a first aspect of the invention there is provided a method of metrology comprising: illuminating a periodic structure with measurement illumination, the periodic structure comprising a pitch greater than 17 nm; detecting scattered illumination resulting from the illuminating step, the scattered illumination comprising a plurality of diffraction orders, each diffraction order having been diffracted or reflected from the periodic structure; wherein the measurement illumination comprises an illumination profile configured to either: substantially prevent overlap of the diffraction orders while providing a plurality of angles of incidence on the periodic structure which span a range greater than 10 degrees in at least one direction; or impose discontinuities in a measurement signal described by the scattered illumination as represented in pupil space, the discontinuities enabling the diffraction orders to be distinguished at least at respective locations in the pupil space of a plurality of illumination edges of the illumination profile.

In a second aspect of the invention there is provided a metrology device operable to perform the method of the first aspect.

In a third aspect of the invention there is provided a method of characterizing a periodic structure using scatterometry, the method comprising: impinging measurement illumination onto the periodic structure, the measurement illumination having a wavelength in the range of 1 nm to 20 nm, to generate a scattered illumination comprising a plurality of diffraction orders, wherein the illumination is configured to converge in incidence and azimuth planes thereby providing simultaneously a plurality of angles of incidence and a plurality of azimuthal angles, and wherein the plurality of angles of incidence spans a range of angles of incidence which is greater than a range of azimuthal angles spanned by the plurality of azimuthal angles, and wherein each diffraction order has been diffracted or reflected from the periodic structure; and collecting at least a portion of the scattered illumination; wherein the illumination comprises an illumination profile configured to either: substantially prevent overlap of the diffraction orders while providing multiple angles of incidence on the periodic structure greater than 10 degrees in at least one direction; or impose discontinuities in a measurement signal described by the scattered illumination as represented in pupil space, the discontinuities enabling the diffraction orders to be distinguished at least at respective locations in the pupil space of a plurality of illumination edges of the illumination profile.

In a fourth aspect of the invention there is provided a method of characterizing a periodic structure using scatterometry, the method comprising: impinging measurement illumination onto the periodic structure, the measurement illumination having a wavelength in the range of 1 nm to 20 nm, to generate a scattered illumination comprising a plurality of diffraction orders, wherein the illumination is configured to converge in incidence and azimuth planes thereby providing simultaneously a plurality of angles of incidence and a plurality of azimuthal angles, and wherein the plurality of angles of incidence spans a range of angles of incidence which is greater than a range of azimuthal angles spanned by the plurality of azimuthal angles, and wherein each diffraction order has been diffracted or reflected from the periodic structure; and collecting at least a portion of the scattered illumination; wherein the periodic structure comprising a pitch greater than 17 nm.

In a fifth aspect of the invention there is provided a method of measuring a periodic structure on a substrate using a scatterometry, the method comprising: forming a converging illumination having a central axis; impinging the converging illumination on the periodic structure to generate scattered illumination comprising a plurality of diffraction orders, such that the central axis forms a non-zero incidence angle relative to a horizontal plane defined by an uppermost surface of the substrate, and the central axis forms a non-zero azimuthal angle relative to an orthogonal to the periodic structure; performing one measurement by collecting only a first diffraction order or both of a zero diffraction order and a first diffraction order from the substrate; wherein the converging illumination comprises an illumination profile configured to either: substantially prevent overlap of the diffraction orders while providing multiple angles of incidence on the periodic structure greater than 10 degrees in at least one direction; or impose discontinuities in a measurement signal described by the scattered illumination as represented in pupil space, the discontinuities enabling the diffraction orders to be distinguished at least at respective locations in the pupil space of a plurality of illumination edges of the illumination profile.

In a sixth aspect of the invention there is provided a method of measuring a periodic structure on a substrate using a scatterometry, the method comprising: forming a converging illumination having a central axis; impinging the converging illumination on the periodic structure such that the central axis forms a non-zero incidence angle relative to a horizontal plane defined by an uppermost surface of the substrate, and the central axis forms a non-zero azimuthal angle relative to an orthogonal to the periodic structure; performing one measurement by collecting only a first diffraction order or both of a zero diffraction order and a first diffraction order from the substrate; wherein the periodic structure comprising a pitch greater than 17 nm.

In a seventh aspect of the invention there is provided an apparatus for measuring a substrate comprising at least one periodic structure using scatterometry, the system comprising: a source for generating measurement illumination having a wavelength in the range of 1 nm to 20 nm; a substrate support for positioning the substrate; a focusing optic positioned between the source and the substrate support for focusing the illumination onto the substrate to generate scattered illumination comprising a plurality of diffraction orders, wherein the measurement illumination simultaneously comprises a plurality of angles of incidence and a plurality of azimuthal angles; a mask being operable to configure illumination profile of the measurement illumination; and a detector for collecting at least a portion of the scattered illumination from the substrate.

The above and other aspects of the invention will be understood from a consideration of the examples described below.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts a simplified schematic drawing of a known metrology device;
- Figure 9 depicts a simplified schematic drawing of diffraction orders in pupil space using a known measurement regime;
- Figure 10 depicts a simplified schematic drawing of a metrology device according to a first example;
- Figure 11(a) depicts a proposed first illumination aperture according to an example; Figure 11(b) shows a simplified schematic drawing of diffraction orders in pupil space using the first illumination aperture; Figure 11(c) shows the diffraction orders in pupil space of Figure 11(b) after shifting/scanning the first illumination aperture;
- Figure 12(a) depicts a proposed second illumination aperture according to an example; Figure 12(b) shows a simplified schematic drawing of diffraction orders in pupil space using the second illumination aperture;
- Figure 13(a) depicts a simplified schematic drawing of a metrology device according to a second example; and Figure 13(b) shows a simplified schematic drawing of diffraction orders using the metrology device of Figure 13(a) and a specific mask;

- Figure 14(a) depicts a proposed third illumination aperture according to an example; Figure 14(b) shows a simplified schematic drawing of diffraction orders in pupil space using the third illumination aperture; and

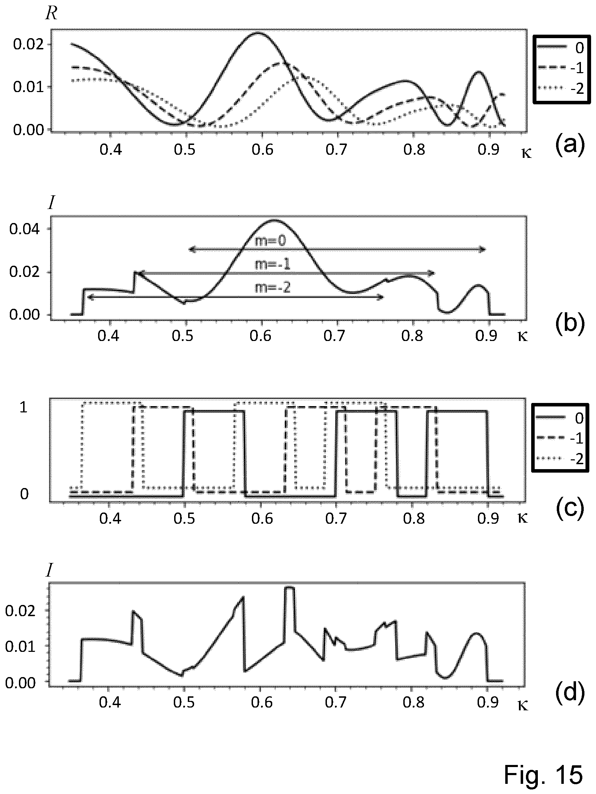

- Figure 15(a) is a plot in pupil space of diffraction efficiencies of a target for three diffraction orders from the target; Figure 15(b) is a plot in pupil space of intensity for a combination of the three diffraction orders as may be obtained from measuring the target characterized by the plot of Figure 15(a); Figure 15(c) is a plot in pupil space of a masking applied to illumination used to measure the target; and Figure 15(d) is a plot in pupil space of intensity for a combination of the three diffraction orders as may be obtained from measuring the target characterized by the plot of Figure 15(a) with illumination masked according to the plot of Figure 15(c).

## DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

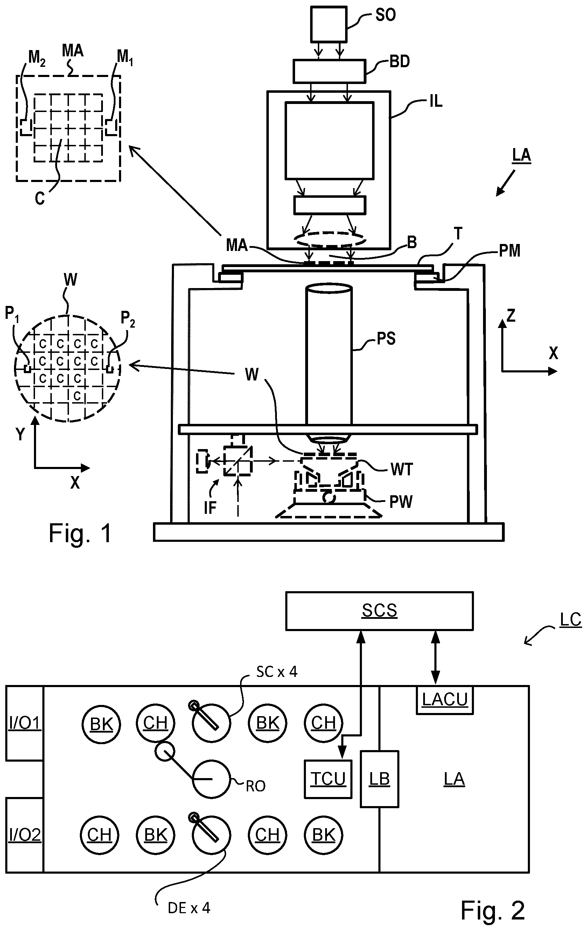

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the angles of incidence of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

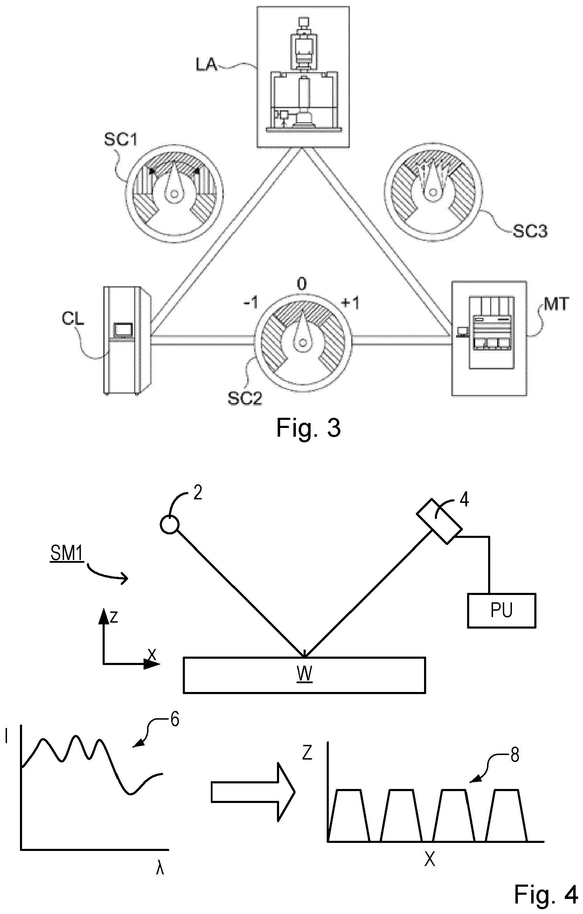

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

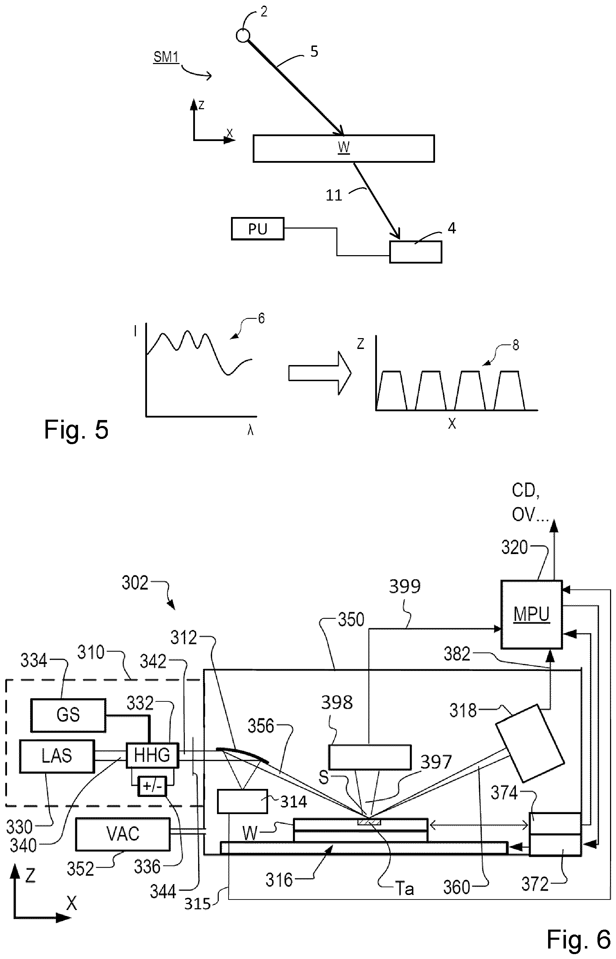

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01 nm, <0.1 nm, <1 nm, between 0.01 nm and 100 nm, between 0.01 nm and 50 nm, between 1 nm and 50 nm, between 1 nm and 20 nm, between 5 nm and 20 nm, and between 10 nm and 20 nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma (DPP) source, soft X-ray laser source, rotating anode source, solid anode source, particle accelerator source, microfocus source, or laser produced plasma (LPP) source.

In an LPP source, a metal is heated by a laser pulse. In a DPP source, a metal is heated by an electrical discharge. In both cases, a plasma is formed which emits soft X-ray or EUV radiation. Examples of suitable metals are tin or lithium (for 13.5 nm wavelength) and gadolinium (for 6.7 nm wavelength). The metal may be in the liquid phase before it is turned into a plasma. The metal may be a mixture comprising other chemical elements, for example, to lower the melting point. The radiation emitted from the plasma may have a bandwidth around the wavelengths. The radiation may be reflected by a mirror which may be a focusing mirror or by a sequence of multiple mirrors. One or more mirrors may be coated with a reflective multilayer coating, such as alternating layers of molybdenum and silicon (for wavelength 13.5 nm), alternating layers of lanthanum and boron carbide (for 6.7 nm), or alternating layers of carbon and boron carbide (for 6.7 nm). Such a mirror reflects over a bandwidth that may be smaller than the radiation emitted from the plasma, which results in radiation that is more monochromatic than the radiation emitted from the plasma. The beam path from the plasma to the target may comprise reflections from mirrors with multilayer coatings and/or grazing-incidence mirrors that reflect over a wider bandwidth than a multilayer mirror. The beam path may comprise an intermediate focus (for example, between two focusing mirrors). A spatial filter may be used in the intermediate focus to reduce the etendue of the beam, thus allowing for a smaller focused spot size on the target Ta.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200 nm to 10$\mu$m, for example in the region of 1 $\mu$m (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen ($N_2$), Oxygen ($O_2$), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Radiation having wavelength(s shorter than 1 nm may suffer from low material contrast. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

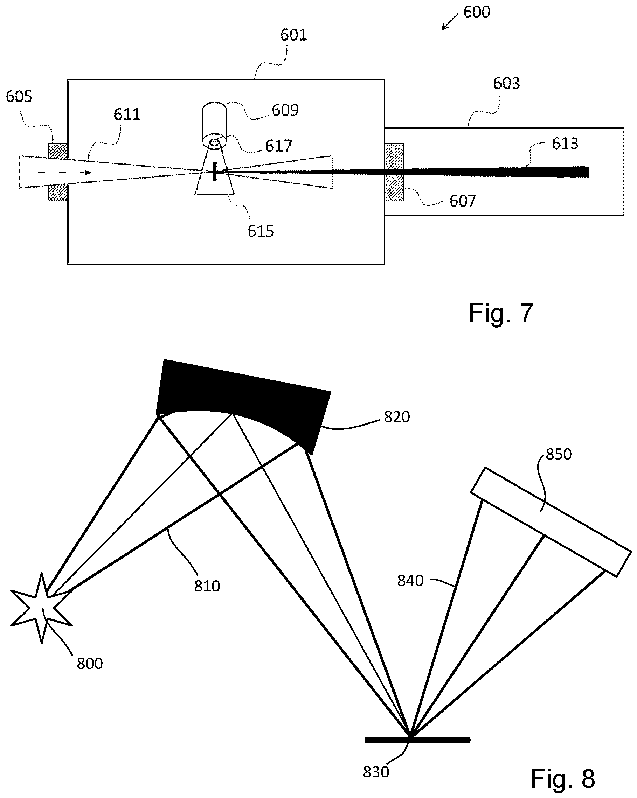

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminum plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 (and/or the measurement radiation for any of the embodiments disclosed herein) may comprise wavelengths in one or more of the ranges of less than 1 nm, less than 0.1 nm, less than 0.01 nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV, SXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV, SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fiber, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimize the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation may be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focused onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibers, the supported propagating modes lead to a spatial profile where the high intensity of the drive radiation overlaps with the high intensity of the HHG radiation. For example, the drive radiation intensity may be centered, in a Gaussian or close-to-Gaussian profile in the far field.

In some metrology methods, one or more parameters of interest relating to the structure(s) being measured may be inferred from scattered radiation having been scattered from the structure(s). The inference may be performed using an inference model, for example. In this context, scattered radiation may comprise any one or more of radiation reflected, transmitted and/or diffracted by the structure(s).

Another type of metrology device uses monochromatic SXR radiation to illumination a periodic structure or target. The resultant diffraction patterns at different angles of incidence can be used to estimate parameters of interest from the target (e.g., CD). A single measurement may comprise information from multiple angles of incidence due to the nonzero focusing NA.

Figure 8 is a highly simplified schematic of such a metrology device. An x-ray or SXR source 800 generates SXR radiation 810. Optionally the generated SXR 810 is monochromatic. The SXR radiation 810 is focused by a focusing optic 820, e.g., a focusing monochromator, onto a target 830. The focusing optic 820 may be such that the target 830 is illuminated with multiple angles of incidence. The scattered radiation 840 (e.g., comprising a plurality of diffraction orders including $\pm 1$ diffraction orders and/or a reflected zeroth order) is detected on a detector 850. Note that the zeroth order may be captured and is termed a "diffraction order" within the context of this disclosure.

Such a system is suitable for $\lambda/d < 1$, where $\lambda$ is the wavelength and d the pitch (period) of the target pattern. The illumination wavelength may be in the range of 1 nm to 20 nm, e.g. 5 nm, and 6.7 nm, or greater than 1.2 nm (1 keV). The focusing numerical aperture (NA) may be 0.17~0.35, which can be reduced down to NA 0.017 (described therein in as full angles terms of degrees).

The NA with respect to a point on the optical axis depends on the half-angle, $\theta_1$, of the maximum cone of light that can enter or exit the lens and the ambient index of refraction.

It Is often desirable to measure targets which have pitches that are far larger than the wavelength. For example, a 2D-periodic target with 400x400 nm pitch is common. For example, even though such devices may start from a fin pattern with a pitch of approximately 50 nm, cuts and connections may result in a unit cell that is a larger multiple of the original fin pitch.

2D pupil coordinates $(\kappa_x, \kappa_y)$ are the projections in pupil space of unit vectors for rays onto the $(x, y)$ plane (i.e., target plane); the full pupil would cover the unit disc. In pupil space, the diffraction orders are separated by a distance $\lambda/d$, which is 0.0125 for d = 400 nm and $\lambda$ = 5 nm. Ideally, the diffraction orders should be separated, which requires illumination with $NA < \lambda/(2d)$, or 0.006 in this example. If the diffraction orders are not separated, applications such as model-based reconstruction and/or 3D imaging (such as described in US20230040124A1 based on an autocorrelation function, incorporated herein by reference) will become more difficult.

However, where the illumination source is not directional, e.g. where a LPP source is used, shrinking the NA will result in most of the power being lost (clipped); e.g., going from NA 0.2 to NA 0.006 will cost a factor $10^3$ in power. Also, for measurement of multiple parameters of interest, it is desirable (if not strictly essential) that diffraction efficiencies are measured over a substantial range of angles of incidence. Note that the substantial range of angles of incidence may be a plurality of angles of incidence which span the substantial range of angles of incidence. This will naturally be the case with illumination at NA 0.2, but not so at NA 0.006. The smaller NA would require scanning the angle, for example by scanning an aperture. As such, if NA is small, substantial range of angles of incidence cannot be captured. Therefore, such an NA reduction leads to lower throughput due to longer exposure times due to power reduction and multiple exposures to obtain a desired angle coverage.

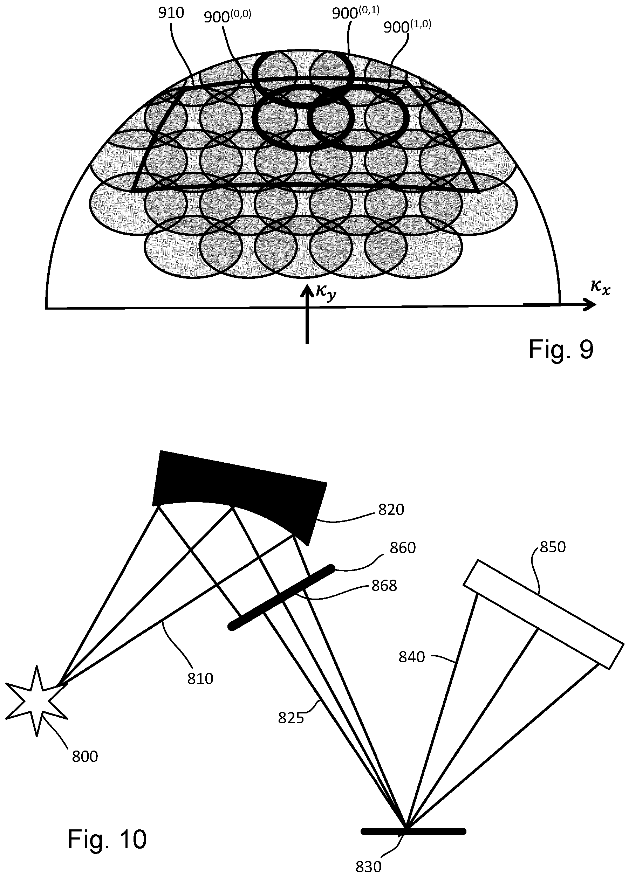

Figure 9 illustrates a typical present illumination arrangement in pupil space $(\kappa_x, \kappa_y)$. Each ellipse represents a diffraction order. The size and shape of each ellipse is largely dictated by the focusing optic and the angle of incidence. (An illumination beam with a circular cross section at angle of incidence $\theta$ with the normal will become an ellipse with aspect ratio $\cos \theta$ in pupil space.) Three diffraction orders are highlighted (bold line) and labeled: zeroth order $900^{(0,0)}$, (1,0) order $900^{(1,0)}$ and the (0,1) order $900^{(0,1)}$. Also shown is the typical coverage 910 of the detector with respect to this pupil space. As can be appreciated there is a large overlap of different diffraction orders. In pupil space, each order is centered around coordinates:

$$\left( \kappa_x^{(0)} + \frac{m_x \lambda}{p_x}, \kappa_y^{(0)} + \frac{m_y \lambda}{p_y} \right),$$

where $m_x$, $m_y$ are the discrete order numbers and $\kappa_{x,y}^{(0)}$ are the pupil coordinates of the illumination (or equivalently, zeroth order).

The overlapping orders means that it is essentially impossible to characterize the diffraction efficiency of the target per diffraction order and therefore determine the parameter(s) of interest. Where the diffraction orders overlap, it is not possible (without using solutions disclosed herein) to disentangle the signals. While Figure 9 does show some regions where there is no overlap per diffraction order, these are typically too small to properly determine the diffraction efficiency over a substantial range of angles of incidence and may not even be present for larger pitches.

To address this, it is proposed to provide illumination comprising an illumination profile configured to either substantially prevent overlap of the diffraction orders, or else to provide discontinuities (step changes) in the measured signal which enable disentanglement of the orders (e.g., in terms of their diffraction efficiency). The discontinuities each correspond to a respective illumination edge (e.g., a mask edge where the illumination profile is configured by masking) which cause a sudden contribution or removal of another order to the signal.

The proposed method and arrangement may comprise placing a mask in the illumination path between the focusing optic and the target. The mask may be a fixed mask or configurable mask (e.g., a spatial light modulator SLM or a coded aperture, or called an encoded mask, a coded aperture element or an encoded aperture, of example of which is described in US10101675B2, incorporated herein by reference). The blocking region of the mask may be completely opaque, or only partially opaque. Alternatively, instead of masking an illumination source, a directly configurable illumination source (i.e., having an illumination profile which can be configured directly) may be used. An example to a configurable illumination source is described in US9134629B2 (incorporated herein by reference), where the configurable radiation source comprises a plurality of reflective elements arranged to receive radiation from a radiation source, the reflective elements being movable between different orientations. In the different orientations, the reflective elements direct radiation towards different locations at a reflective component in a pupil plane of the illumination system, thereby forming different illumination modes. Each reflective element is moveable between a first orientation, which directs radiation towards a first location the pupil plane, and a second orientation, which directs radiation towards a second location in the pupil plane. The first orientation and the second orientation of the reflective element are defined by end stops.

Figure 10 illustrates such an arrangement, where a mask 860, which may be one or more of the masks and/or apertures discussed above, is provided between the focusing optic 820 and target 830. Alternatively, the mask 860 may be placed between the source 800 and the focusing optic 820. Elements already described in relation to Figure 8 will not be described again. The mask 860 comprises at least one aperture configured to prevent overlap of the diffraction orders in pupil space, while being sufficiently large to provide a good range of angles of incidence for the masked illumination 825 on the target 830, e.g., in x and/or y. The illumination profile may be such to maximize the extent of the diffraction orders (in at least one direction) in pupil space without their significant overlap, e.g., such that their separation is minimized in at least one direction. As such, the diffracted orders may be tessellated (in at least one direction) in pupil space.

For example, the range of angles of incidence may be greater or equal to 10°, 12°, 14°, 16°, 18°, 20°, 25° or 30° in x and/or y. This may apply to a convergence angle greater or equal to 6°, greater or equal to 12°, greater or equal to 18°, greater or equal to 24° (e.g., one of 6°, 12°, 18°, 24°). Note that $NA = \sin(\phi_c/2)$ where $\phi_c$ is the convergence angle.

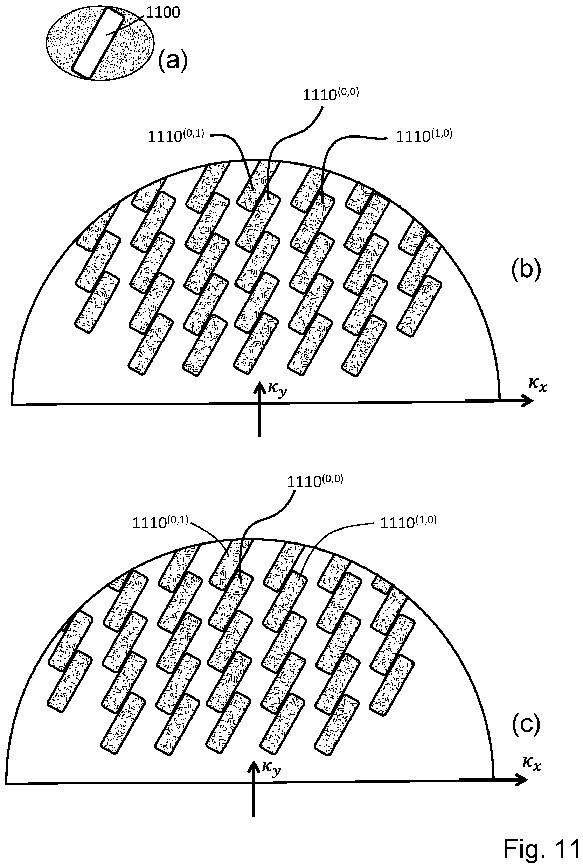

Figure 11(a) shows an example aperture shape 1100 which may be used for the mask 860 so as to provide a large range of angles of incidence without overlapping orders. In this example, the shape comprises a tilted rectangle, tilted slit or parallelogram. Note that the shape fits inside the original illumination ellipse, which would be defined by the size of the focusing optic.

Figure 11(b) illustrates resultant diffraction orders in pupil space. As with Figure 9, three of the diffraction orders are labeled: zeroth order $1110^{(0,0)}$, (1,0) order $1110^{(1,0)}$ and the (0,1) order $1110^{(0,1)}$. The range of angles maps to the distance from the center of the pupil disc. With an aperture 1100 shaped as a tilted slit or tilted rectangle, it is possible to cover a large angle range without overlapping orders and therefore maximize the number of fringes captured. It can be appreciated in this respect that the aforementioned US10101675B2 describes a metrology device uses measurement wavelengths less than the width and height of the structures being measured, resulting in interference fringes of multiple cycles being available which provide sensitivity to height, width and line shape. For more detail, reference should be made to this publication.

This aperture 1100 may be scanned (e.g., shifted one or more times), such that multiple exposures are obtained, each corresponding to a different range of azimuthal angles and/or angles of incidence. Figure 11(c) illustrates the diffraction pattern of Figure 11(b) after such a shift of the aperture 1100. Note that the orders have shifted with respect to the $\kappa_y$ axis. Scanning the aperture (illumination) in this method is generally applicable to many of the concepts disclosed herein.

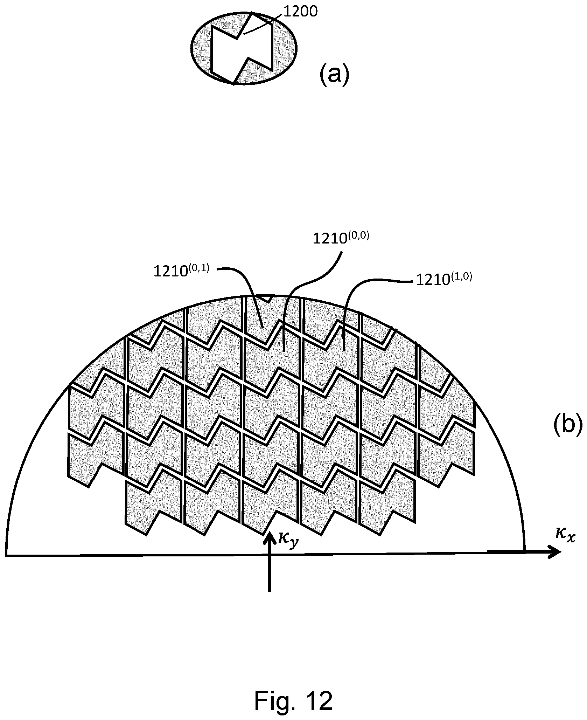

Figure 12(a) shows another example aperture shape 1200 which may be used for the mask 860 so as to further increase the range of angles of incidence without overlapping orders. In this example, an irregular shape is optimized to maximize the extent of the diffraction orders in x and y without overlapping. Again, the shape fits inside the original illumination ellipse.

Figure 12(b) illustrates resultant diffraction orders in pupil space. As with Figure 9, three of the diffraction orders are labeled: zeroth order $1210^{(0,0)}$, (1,0) order $1210^{(1,0)}$ and the (0,1) order $1210^{(0,1)}$. The aperture shape 1200 is such that the diffraction orders are (fully) tessellated in pupil space.

A disadvantage of illumination shapes such defined by apertures 1100, 1200 is that they require customization for each sample depending on sample pitch and even sample orientation. This is not such a problem when fully configurable illumination is used (e.g., a configurable illuminator or configurable mask/SLM). However this may be more of an issue when a fixed mask is used.

Note that the proposed methods may provide for an aperture optimization for maximizing the angle of incidence coverage without overlap of diffraction orders (e.g., similar in principle to source mask optimization SMO). This may be done with both a regular shape such as a tilted rectangle/quadrilateral/slit (e.g., the optimization being constrained to such a shape) or to allow for any irregular shape. The result of such an optimization may be used to manufacture one or more fixed masks or configure a configurable illuminator or configurable mask.

In other examples, to prevent the need to configure the illumination for particular targets/orientations, it is proposed to allow the diffraction orders to overlap, but in such a manner that it is possible to disentangle the orders (at least approximately to a sufficient degree). Such an approach may comprise providing a mask with a plurality of apertures which provide discontinuities in the measured signal. The discontinuities each correspond to a respective illumination edge or mask edge, each discontinuity resulting from a sudden contribution or removal of another order to the signal due to the mask edge.

The mask, for example, may comprise a plurality of apertures (or more generally individual illumination sources), each with a small NA; e.g., each having an NA below 0.015, below 0.012, below 0.01, below 0.008 or equal to or below 0.006. As such, the diameter of the holes is such that diffraction orders from the light passing through a single hole will not (completely) overlap.

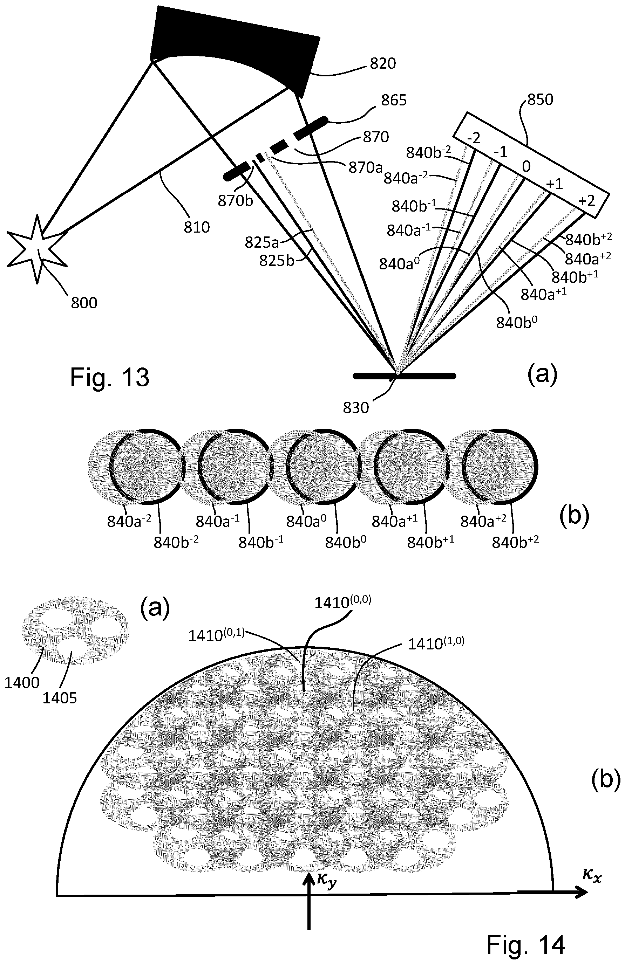

Figure 13(a) illustrates such an arrangement, where a mask 865, which may be one or more of the masks and/or apertures discussed above, is provided between the focusing optic 820 and target 830, the mask 865 comprising a plurality of apertures 870. Light paths 825a, 825b respectively from each of aperture 870a, 870b are shown in gray and black. The corresponding diffraction orders within the scattered radiation are also shown. These diffraction orders in this example comprise a zeroth diffraction order $840a^0$, first diffraction orders $840a^{+1}$, $840a^{-1}$, and second diffraction orders $840a^{+2}$, $840a^{-2}$, corresponding to illumination via aperture 870a and a zeroth diffraction order $840b^0$, first diffraction orders $840b^{+1}$, $840b^{-1}$, and second diffraction orders $840b^{+2}$, $840b^{-2}$ corresponding to illumination via aperture 870b.

Figure 13(b) shows these diffraction orders as detected on the detector 850; the corresponding diffraction orders are partially overlapping, but slightly offset. Because apertures have sharp edges, it is possible to individually discern the diffraction orders. Thus, it is possible to separately determine, in a single exposure, diffraction efficiencies per diffraction order and for different angles of incidence. How this can be done will be explained below.

In one embodiment, the overlapping orders occurs for periodic structure comprising a pitch greater than 17 nm measured by the metrology device as shown in Figure 8, while overlapping orders is suppressed or eliminated when the metrology device as shown in Figure 10 or Figure 13 is used for the same measurement.

Figure 13(a) shows a simple 1D arrangement for clarity. However, the apertures 870 may be arranged in a 2D arrangement, so as to capture variation both in angle of incidence and in the azimuthal angle. The apertures may be arranged on a regular grid or comprise a quasi-random arrangement. The apertures can be circular or have different shapes (rectangles, squares, or triangles in varying orientations and combinations). Multiple masks can be used; masks can be swapped for multiple measurements on the same target or a suitable mask (regarding spacing and/or diameter of the holes) can be chosen for a given target pitch.

Figure 14(a) illustrates such a 2D arrangement, where a mask 1400 comprises three apertures 1405 arranged in a 2D configuration. Figure 14(b) illustrates resultant diffraction orders in pupil space. As with Figure 9, three of the diffraction orders are labeled: zeroth order $1410^{(0,0)}$, (1,0) order $1410^{(1,0)}$ and the (0,1) order $1410^{(0,1)}$.

A method for processing the measured signal comprising overlapping orders, the signal comprising discontinuities due to illumination edges, as may be obtained from the arrangement of Figure 13 and/or Figure 14, will now be described with reference to Figure 15.

Suppose that the target has a diffraction efficiency:

$$R\left(m_x, m_y, \kappa_x^{(0)}, \kappa_y^{(0)}\right).$$

The general approach would be to have a prior probability on the 'true' diffraction efficiency, which is assumed to be smooth for small variations in $\kappa_{x,y}$. It may be assumed to be more smooth in one direction (for example in $\kappa_x$ but less so in $\kappa_y$).

The illumination has a known exposure (in $J/m^2$ units) $I_0(\kappa_x, \kappa_y)$. The exposure as measured in pupil space is:

$$I\left(\kappa_x, \kappa_y\right) = \sum_{m_x, m_y} I_0\left(\kappa_x - \frac{m_x \lambda}{p_x}, \kappa_y - \frac{m_y \lambda}{p_y}\right) \cdot R\left(m_x, m_y, \kappa_x - \frac{m_x \lambda}{p_x}, \kappa_y - \frac{m_y \lambda}{p_y}\right), \quad \text{(eq. 1)},$$

where $p_x$, $p_y$ are the x- and y-pitches of the sample. The unknown being sought is diffraction efficiency R; for each order $m_x$, $m_y$, R can be estimated on a simply connected domain (i.e., domain without holes) in $\kappa_x$, $\kappa_y$, using the assumed smoothness.

Referring to a 1D example illustrated in Figure 15, Figure 15(a) shows example diffraction efficiencies R in pupil space $\kappa$ (the offset R factor in eq. (1)), here in one dimension written as $R(m, \kappa)$. These are the functions, i.e., one function (signal contribution value) per diffraction order m, that that are to be estimated. These diffraction efficiencies R are generally smooth functions of $\kappa$.

Figure 15(b) shows the measured image exposure $I(\kappa)$ (assuming illumination $I_0 = 1$ for $0.5 < \kappa < 0.9$), which is the sum of three diffraction orders (m = 0, -1, - 2) that are substantially overlapping. Only for $\kappa < 0.43$ and $\kappa > 0.83$ does the signal result from a single diffraction order (m = -2 and m = 0, respectively); for $0.43 < \kappa < 0.83$, the signal comprises overlapping diffraction orders. In particular, it is essentially impossible to split the signal into separate diffraction orders for the range $0.55 < \kappa < 0.7$.

Figure 15(c) shows the mask. The mask for order $m = 0$ is the original mask; the masks for the other orders are shifted in steps of $\lambda/p$ for pitch $p$. The mask function takes values 0 and 1; each function per order is slightly displaced vertically to make them easier to distinguish in the drawing.

Figure 15(d) shows the measured exposure $I(\kappa)$, assuming the diffraction efficiencies in Figure 15(a) and the mask in Figure 15(c). For $\kappa < 0.43$, order $m = -2$ is isolated. At $\kappa = 0.43$, there is a discontinuity as order $m = -1$ starts contributing. The size of the step (i.e., in this specific example from 0.01 to 0.02) is the value R(-1, 0.43). The slope $I'(m, \kappa) := dI/d\kappa$ can also be determined, which is discontinuous. The step in slope can be defined as:

$$\Delta I'(\kappa) := I'(\kappa - \delta) - I'(\kappa + \delta),$$

where $\delta$ is a small number. This step in slope is related to the derivative R'(- 1, 0.43). This can be done for other pupil space values, e.g., specifically where there is a discontinuity (each discontinuity corresponding to a mask edge in Figure 15(c)). At each of these discontinuities, the intensity contribution per diffraction order (which are present at that particular $\kappa$) can be distinguished by assuming that the jump (or fall) is the result of the diffraction order which is being added (or removed) from the signal due to the mask edge (more generally illumination edge). Based on this, the diffraction efficiency R and its derivative R' can be determined for each distinguished diffraction order. These estimated diffraction efficiencies and derivatives can be combined to estimate the diffraction efficiency $R$ for each diffraction order over the full range of $\kappa$ (e.g., assuming each diffraction efficiency is smooth over $\kappa$).

A practical implementation to achieve this for 2D data will now be described. Beginning with eq. (1) where $I(\kappa_x, \kappa_y)$ is measured and sampled on a suitable grid, for example $N = 10^6$ grid points (1000x1000 grid). Let M be the number of diffraction orders (for example if $|m_{x,y}| \leq 5$, then $M = (2 \cdot 5 + 1)^2 = 121$. Equation eq. (1) thus represents a system of N linear equations with NM unknowns. The prior on smoothness can be expressed as a minimization of the second spatial derivative of $R$, which can be numerically approximated (for a given $m_x$, $m_y$ pair) as:

$$\nabla^2 R(i,j) = \frac{R[i + 1,j] + R[i,j + 1] + R[i - 1,j] + R[i,j - 1] - 4R[i,j]}{\Delta \kappa^2} \quad (eq.\, 2)$$

where [i,j] refers to the integer indices of the discrete samples on the grid and $\Delta\kappa$ is the step size of the grid. Thus, NM equations can be added of the form:

$$\mu_1 \nabla^2 R = 0 \quad (eq.\, 3)$$

for all $m_x$, $m_y$, $i$, $j$, where $\mu_1$ is a regularization parameter. Furthermore, another NM equations can be added, having the form:

$$\mu_2 R = 0, \quad (eq.\, 4)$$

to represent a prior probability that diffraction efficiencies will generally be small numbers, with another regularization parameter $\mu_2$. In total, there will be $(2M + 1)N$ equations with $NM$ unknowns, which makes an overdetermined sparse system, which can be solved efficiently using a least-squares solver. The regularization parameters $\mu_{1,2}$ may be tuned to strike a good balance between suppressing artifacts from noise while still producing smooth estimates for R. This tuning can be done based on simulation data.

There are many refinements possible for the above method. For example, the smoothness requirement (eq. 3) may be anisotropic (e.g., depending on the expected orientation of fringes). For context, a diffraction pattern having mostly non-overlapping orders may comprise fringes parallel with the $\kappa_x$ axis. In another refinement, the regularization parameters $\mu_1$, $\mu_2$ may be made dependent on the diffraction order numbers. Alternatively or in addition, the right-hand side of eq. (4) may be made nonzero and to depend on the diffraction-order number. Also, the signal model (eq. 1) may be refined to account for blurring.

Because the information is carried by the behavior of the image signal near edges of the illumination mask, good candidate illumination masks may have a large total edge length compared to the diameter of the original illumination ellipse. The illumination masks in Figures 13 and 14(a), each having three apertures, is for illustration purposes (although can be used and within the scope of the concepts disclosed); a larger number of smaller apertures is likely to perform better. For example, the number of apertures may be greater than 5, greater than 10, greater than 50 or greater than 75, greater than 100 or greater than 150.

It can be appreciated that it may be desirable to for the apertures to have an angular size $\alpha$ smaller than the fringe period over angle of incidence $\theta$; if the target pattern height is h, then an upper limit for the angular size may be:

$$\alpha < \frac{\lambda}{2h\sin\theta}.$$

For example, $\lambda$ = 10 nm, $h$ = 200 nm, and $\theta$ = 60 deg results in $\alpha$ < 30 mrad. This example does not consider the azimuth angle; since the variation of R with azimuth (or $\kappa_x$) is generally smoother, it will probably work with (slightly) larger $\alpha$ values.

There are two limitations on how small the apertures may be. The apertures should be sufficiently large to maintain good imaging of the source to the target. The spot on the target Ta could be 20 $\mu$m diameter (incoherent); the diffraction limit for a circular aperture has a diameter of approximately 2.5 $\lambda/NA$; hence, the NA of each aperture should be greater than 0.0006, for example. Also, the 'shadows' of the edges on the measured image will be somewhat blurry due to fundamental optical limitations. If the focus spot size (on the sample) is $w_0$ and the distance from sample to image sensor is $L$ (or the distance from mask to sample, whichever is smaller), then the angular size $\alpha$ of the apertures in the mask should be designed as $\alpha > w_0/L$ to prevent the blurring effect from washing out the discrete shadows. For example, with $w_0$ = 20 $\mu$m and $L$ = 50 mm, the requirement is $\alpha$ > 0.4 mrad. This requirement will usually be satisfied if the diffraction limit requirement is satisfied.

The concepts described herein may be used to measure any targets, but in particular targets having a larger pitch, e.g., a pitch or effective pitch greater than 17 nm, greater than 30 nm, greater than 50 nm, greater than 70 nm, greater than 90 nm or greater than 100 nm. One or more parameters of interest may be determined from the resultant metrology data. For example, a target reconstruction may be performed (e.g., using autocorrelation methods as disclosed in WO2021/121906, which is incorporated herein by reference).

The measurement illumination (e.g., configured measurement illumination 868 of Figure 10 or masked measurement illumination of Figure 13) may be impinged upon (i.e., used to illuminate) the target or periodic structure, such that it is configured to converge in incidence and azimuth planes thereby providing simultaneously a plurality of angles of incidence and a plurality of azimuthal angles. The plurality of angles of incidence may span a range of angles of incidence which is greater than a range of azimuthal angles spanned by the plurality of azimuthal angles.

The measurement illumination (e.g., configured measurement illumination 868 of Figure 10 or masked measurement illumination of Figure 13) may comprise a converging illumination (e.g., due to the action of focusing optic 820) having a central axis. This converging illumination may be impinged upon the periodic structure to generate the scattered illumination comprising a plurality of diffraction orders. The impinging may be such that the central axis forms a non-zero incidence angle relative to a horizontal plane defined by an uppermost surface of the substrate, and the central axis forms a non-zero azimuthal angle relative to an orthogonal to the periodic structure.

In any of the embodiments described above, the measurement may be performed by collecting only a first diffraction order or both of a zeroth diffraction order and a first diffraction order of the scattered radiation.

In the context of this disclosure, the azimuthal angle is the angle of the measurement illumination with respect to the direction of structure symmetry of the target, as opposed to angle of incidence which is the angle of the measurement illumination with respect to a normal to the substrate plane.

The apparatuses described herein may comprise a chamber in which the main components, such as the illumination source, focusing optic, mask, substrate support and detector are housed. The chamber may comprise, for example, a first sub-chamber and a second sub-chamber. The first sub-chamber may have the source located within. The measurement illumination generated by the source may be transmitted through a transmissive region formed between the first-sub chamber and the second sub-chamber. The second sub-chamber may have the substrate support located therein. The focusing optic, mask and detector may also be located within the second sub-chamber. In a further embodiment, the focusing optic, mask and detector is located within the first sub-chamber. In a further embodiment, the focusing optic, mask and detector is located in between the first sub-chamber and the second sub-chamber.

The apparatuses described herein may comprise an electron gun to generate the measurement illumination from the source. In one such embodiment, the illumination source is an anode and the electron gun is directed at the anode. In a particular example, the anode is for generating low energy X-ray illumination and includes a material such as, but not limited to, carbon (C), molybdenum (Mo) or Rhodium (Rh). In one example, the electron gun is an approximately 1 keV electron gun. A magnetic electron suppression device may be included between the illumination source and the focusing optic. The magnetic electron suppression may be configured to suppress electrons emitted, in addition to the measurement illumination, from the source as a result of using the electron beam from the electron gun.

The concepts herein are applicable to broadband illumination in addition to monochromatic illumination. For example, the measurement illumination may comprise a single wavelength within the range of 1 to 20 nm or multiple wavelengths within this range.

Further embodiments are disclosed in the subsequent numbered clauses:

1. A method comprising:

illuminating a periodic structure with measurement illumination, the periodic structure comprising a pitch greater than 17 nm;
detecting scattered illumination resulting from the illuminating step, the scattered illumination comprising a plurality of diffraction orders, each diffraction order having been diffracted or reflected from the periodic structure;
wherein the measurement illumination comprises an illumination profile configured to either:

substantially prevent overlap of the diffraction orders while providing a plurality of angles of incidence on the periodic structure which span a range greater than 10 degrees in at least one direction; or
impose discontinuities in a measurement signal described by the scattered illumination as represented in pupil space, the discontinuities enabling the diffraction orders to be distinguished at least at respective locations in the pupil space of a plurality of illumination edges of the illumination profile.

2. A method according to clause 1, wherein the periodic structure comprises a pitch greater than 30 nm.
3. A method according to clause 1, wherein the periodic structure comprising a pitch greater than 70 nm.
4. A method according to any preceding clause, wherein the measurement illumination comprises an illumination profile configured to substantially prevent overlap of the diffraction orders while providing a plurality of angles of incidence on the periodic structure spanning a range greater than 10 degrees in at least one direction.
5. A method according to clause 4, wherein the illumination profile comprises a tilted rectangle profile, tilted slit profile, or parallelogram profile.
6. A method according to clause 4, wherein the illumination profile comprises an irregular profile which maximizes the range of angle of incidence spanned by the plurality of angles of incidence and/or a range of azimuthal angles on the periodic structure without overlap of diffraction orders.
7. A method according to clause 4, 5 or 6, comprising an optimization step for maximizing the range of angle of incidence spanned by the plurality of angles of incidence and/or a range of azimuthal angles on the periodic structure without overlap of diffraction orders.
8. A method according to any of clauses 1 to 3, wherein the illumination profile is configured to impose the discontinuities in a measurement signal described by the scattered illumination as represented in pupil space, the illumination profile comprising a plurality of illumination sources each illumination source corresponding to a numerical aperture below 0.015.
9. A method according to clause 8, wherein each illumination source corresponding to a numerical aperture below 0.010.
10. A method according to clause 8 or 9, wherein the plurality of illumination sources is obtained by masking an illumination source with a mask comprising a plurality of apertures.
11. A method according to any of clauses 8 to 10, wherein the plurality of illumination sources comprises more than 3.
12. A method according to any of clauses 8 to 10, wherein the plurality of illumination sources comprises more than 100.
13. A method according to any of clauses 8 to 12, wherein the plurality of apertures are arranged in a 2-dimensional arrangement.
14. A method according to any of clauses 8 to 13, comprising distinguishing a respective signal contribution value to the measurement signal at each the discontinuity from each diffraction order present at that discontinuity, from at least a magnitude of the discontinuity.
15. A method according to clause 14, comprising estimating an overall signal contribution to the measurement signal per diffraction order from each of the signal contribution values determined in the distinguishing step and their derivatives.
16. A method according to clause 15, wherein the estimation assumes a smooth signal contribution per diffraction order in at least one direction.
17. A method according to any of clauses 8 to 16, comprising distinguishing respective signal contribution values for each diffraction order to the measurement signal by solving at least a system of linear equations for each of a plurality of sample points for the measurement signal subject to a smoothness prior.
18. A method according to clause 17, wherein the smoothness prior comprises a minimization of the second spatial derivative of the respective signal contribution values per diffraction order.
19. A method according to any of clauses 14 to 18, wherein the signal contribution to the measurement signal is estimated in terms of diffraction efficiency of the periodic structure.
20. A method according to any preceding clause, comprising scanning the measurement illumination to obtain a plurality of exposures, each corresponding to a different range of angles of incidence for the measurement illumination on the periodic structure.
21. A method according to any preceding clause, comprising masking the illumination to obtain the illumination profile.
22. A method according to any preceding clause, comprising configuring a configurable illumination source and/or configurable mask to obtain the illumination profile.

23. A method of characterizing a periodic structure using scatterometry, the method comprising:

impinging measurement illumination onto the periodic structure, the measurement illumination having a wavelength in the range of 1 nm to 20 nm, to generate a scattered illumination comprising a plurality of diffraction orders, wherein the illumination is configured to converge in incidence and azimuth planes thereby providing simultaneously a plurality of angles of incidence and a plurality of azimuthal angles, and wherein the plurality of angles of incidence spans a range of angles of incidence which is greater than a range of azimuthal angles spanned by the plurality of azimuthal angles, and wherein each diffraction order has been diffracted or reflected from the periodic structure; and
collecting at least a portion of the scattered illumination;
wherein the illumination comprises an illumination profile configured to either:

substantially prevent overlap of the diffraction orders while providing multiple angles of incidence on the periodic structure greater than 10 degrees in at least one direction; or
impose discontinuities in a measurement signal described by the scattered illumination as represented in pupil space, the discontinuities enabling the diffraction orders to be distinguished at least at respective locations in the pupil space of a plurality of illumination edges of the illumination profile.

24. A method of characterizing a periodic structure using scatterometry, the method comprising:

impinging measurement illumination onto the periodic structure, the measurement illumination having a wavelength in the range of 1 nm to 20 nm, to generate a scattered illumination comprising a plurality of diffraction orders, wherein the illumination is configured to converge in incidence and azimuth planes thereby providing simultaneously a plurality of angles of incidence and a plurality of azimuthal angles, and wherein the plurality of angles of incidence spans a range of angles of incidence which is greater than a range of azimuthal angles spanned by the plurality of azimuthal angles, and wherein each diffraction order has been diffracted or reflected from the periodic structure; and
collecting at least a portion of the scattered illumination;
wherein the periodic structure comprising a pitch greater than 17 nm.

25. A method according to clause 24, wherein the periodic structure comprising a pitch greater than 30 nm.
26. A method according to clause 23, 24 or 25, wherein the step of collecting at least a portion of the scattered illumination comprising using a detector to simultaneously sample a scattered signal intensity of the at least the portion of the scattered illumination that is scattered from the illuminating over the range of angles of incidence and the range of azimuthal angles.
27. A method of measuring a periodic structure on a substrate using a scatterometry, the method comprising:

forming a converging illumination having a central axis;
impinging the converging illumination on the periodic structure to generate scattered illumination comprising a plurality of diffraction orders, such that the central axis forms a non-zero incidence angle relative to a horizontal plane defined by an uppermost surface of the substrate, and the central axis forms a non-zero azimuthal angle relative to an orthogonal to the periodic structure;
performing one measurement by collecting only a first diffraction order or both of a zero diffraction order and a first diffraction order from the substrate;
wherein the converging illumination comprises an illumination profile configured to either:

substantially prevent overlap of the diffraction orders while providing multiple angles of incidence on the periodic structure greater than 10 degrees in at least one direction; or
impose discontinuities in a measurement signal described by the scattered illumination as represented in pupil space, the discontinuities enabling the diffraction orders to be distinguished at least at respective locations in the pupil space of a plurality of illumination edges of the illumination profile.

28. A method of measuring a periodic structure on a substrate using a scatterometry, the method comprising:

forming a converging illumination having a central axis;
impinging the converging illumination on the periodic structure such that the central axis forms a non-zero incidence angle relative to a horizontal plane defined by an uppermost surface of the substrate, and the central axis forms a non-zero azimuthal angle relative to an orthogonal to the periodic structure;

performing one measurement by collecting only a first diffraction order or both of a zero diffraction order and a first diffraction order from the substrate;
wherein the periodic structure comprising a pitch greater than 17 nm.

29. A method according to clause 28, wherein the periodic structure comprising a pitch greater than 30 nm.
30. A method of characterizing a periodic structure using a scatterometry, the method comprising:

impinging measurement illumination onto the periodic structure, the measurement illumination having a wavelength in the range of 1 nm to 20 nm, to generate scattered illumination comprising a plurality of diffraction orders, while configuring the illumination to converge in incidence and azimuth planes to thereby simultaneously provide a plurality of angles of incidence and a plurality of azimuthal angles; and
sampling an intensity of at least a portion of the scattered illumination;
wherein the measurement illumination comprises an illumination profile configured to either:
substantially prevent overlap of the diffraction orders while providing multiple angles of incidence on the periodic structure greater than 10 degrees in at least one direction; or
impose discontinuities in a measurement signal described by the scattered illumination as represented in pupil space, the discontinuities enabling the diffraction orders to be distinguished at least at respective locations in the pupil space of a plurality of illumination edges of the illumination profile.

31. A method of characterizing a periodic structure using a scatterometry, the method comprising:

impinging measurement illumination onto the periodic structure, the measurement illumination having a wavelength in the range of 1 nm to 20 nm, to generate scattered illumination comprising a plurality of diffraction orders, while configuring the illumination to converge in incidence and azimuth planes to thereby simultaneously provide a plurality of angles of incidence and a plurality of azimuthal angles; and
sampling an intensity of at least a portion of the scattered illumination;
wherein the periodic structure comprising a pitch greater than 17 nm.

32. A method according to clause 31, wherein the periodic structure comprising a pitch greater than 30 nm.
33. An apparatus for measuring a substrate comprising at least one periodic structure using scatterometry, the system comprising:

a source for generating measurement illumination having a wavelength in the range of 1 nm to 20 nm;
a substrate support for positioning the substrate;
a focusing optic positioned between the source and the substrate support for focusing the illumination onto the substrate to generate scattered illumination comprising a plurality of diffraction orders, wherein the measurement illumination simultaneously comprises a plurality of angles of incidence and a plurality of azimuthal angles;
a mask being operable to configure illumination profile of the measurement illumination; and
a detector for collecting at least a portion of the scattered illumination from the substrate.

34. An apparatus according to clause 33, wherein the mask is operable to configure illumination profile of the measurement illumination to either:

substantially prevent overlap of the diffraction orders while providing the plurality of angles of incidence on the periodic structure greater than 10 degrees in at least one direction; or
impose discontinuities in a measurement signal described by the scattered illumination as represented in pupil space, the discontinuities enabling the diffraction orders to be distinguished at least at respective locations in the pupil space of a plurality of illumination edges of the illumination profile.

35. An apparatus according to clause 33 or 34, wherein the periodic structure comprises a pitch greater than 17 nm.
36. An apparatus according to clause 33 or 34, wherein the periodic structure comprises a pitch greater than 30 nm.
37. An apparatus according to any of the clauses 33 to 36, wherein the measurement illumination comprises a range of angles of incidence that is greater than a range of azimuthal angles.
38. A apparatus according to any of the clauses 33 to 37, further comprising a first sub-chamber and a second sub-chamber; wherein the source is located within the first sub-chamber and configured to generate the measurement illumination which passes through a transmissive region formed between the first-sub chamber and the second sub-chamber; and wherein the substrate support is located within the second-sub-chamber.
39. A apparatus according to any of the clauses 33 to 38, further comprising a magnetic electron suppression device being configured to suppress electrons emitted, in addition to the measurement illumination, from the source as a result of using an electron beam from an electron gun.

40. An apparatus being operable to perform the method of any of clauses 1 to 22.

41. An apparatus according to clause 40, further comprising:

a substrate support for supporting a substrate;
a focusing optic for focusing the illumination onto the substrate.

42. An apparatus according to clause 41, comprising:
a mask located between the focusing optic and substrate support being operable to impose the illumination profile.

43. An apparatus according to clause 42, wherein the mask comprises a static mask.

44. An apparatus according to clause 42, wherein the mask comprises a configurable mask or spatial light modulator.

45. An apparatus according to clause 40 or 41, comprising a configurable illumination device for providing the illumination with the illumination profile.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in any other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an assessment apparatus or an assessment system, e.g. an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that

EP 4 772 941 A1

the invention, where the context allows, may be practiced with all electromagnetic radiations, including radio waves, microwaves, infrared, (visible) light, ultraviolet, X-rays, and gamma rays.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. A method comprising:

   illuminating a periodic structure with measurement illumination, the periodic structure comprising a pitch greater than 17 nm;
   detecting scattered illumination resulting from the illuminating step, the scattered illumination comprising a plurality of diffraction orders, each diffraction order having been diffracted or reflected from the periodic structure;
   wherein the measurement illumination comprises an illumination profile configured to either:

   substantially prevent overlap of the diffraction orders while providing a plurality of angles of incidence on the periodic structure which span a range greater than 10 degrees in at least one direction; or
   impose discontinuities in a measurement signal described by the scattered illumination as represented in pupil space, the discontinuities enabling the diffraction orders to be distinguished at least at respective locations in the pupil space of a plurality of illumination edges of the illumination profile.

2. A method according to claim 1, wherein the measurement illumination comprises an illumination profile configured to substantially prevent overlap of the diffraction orders while providing the plurality of angles of incidence on the periodic structure spanning the range greater than 10 degrees in at least one direction, and the illumination profile comprises a tilted rectangle profile, tilted slit profile, or parallelogram profile.

3. A method according to claim 1, wherein the measurement illumination comprises an illumination profile configured to substantially prevent overlap of the diffraction orders while providing the plurality of angles of incidence on the periodic structure spanning the range greater than 10 degrees in at least one direction, and the illumination profile comprises an irregular profile which maximizes the range of angle of incidence spanned by the plurality of angles of incidence and/or a range of azimuthal angles on the periodic structure without overlap of diffraction orders.

4. A method according to claim 1, 2 or 3, comprising an optimization step for maximizing the range of angle of incidence spanned by the plurality of angles of incidence and/or a range of azimuthal angles on the periodic structure without overlap of diffraction orders.

5. A method according to claim 1, wherein the illumination profile is configured to impose the discontinuities in the measurement signal described by the scattered illumination as represented in pupil space, the illumination profile comprising a plurality of illumination sources each illumination source corresponding to a numerical aperture below 0.015.

6. A method according to claim 5, wherein the plurality of illumination sources is obtained by masking an illumination source with a mask comprising a plurality of apertures.

7. A method according to claim 5 or 6, wherein the plurality of illumination sources comprises more than 3.

8. A method according to any of claims 5 to 7, wherein the plurality of apertures are arranged in a 2-dimensional arrangement.

9. A method according to any preceding claim, comprising configuring a configurable illumination source and/or configurable mask to obtain the illumination profile.

10. A method of characterizing a periodic structure using scatterometry, the method comprising:

impinging measurement illumination onto the periodic structure, the measurement illumination having a wavelength in the range of 1 nm to 20 nm, to generate a scattered illumination comprising a plurality of diffraction orders, wherein the illumination is configured to converge in incidence and azimuth planes thereby providing simultaneously a plurality of angles of incidence and a plurality of azimuthal angles, and wherein the plurality of angles of incidence spans a range of angles of incidence which is greater than a range of azimuthal angles spanned by the plurality of azimuthal angles, and wherein each diffraction order has been diffracted or reflected from the periodic structure; and

collecting at least a portion of the scattered illumination;

wherein the illumination comprises an illumination profile configured to either:

substantially prevent overlap of the diffraction orders while providing multiple angles of incidence on the periodic structure greater than 10 degrees in at least one direction; or

impose discontinuities in a measurement signal described by the scattered illumination as represented in pupil space, the discontinuities enabling the diffraction orders to be distinguished at least at respective locations in the pupil space of a plurality of illumination edges of the illumination profile.

11. A method of measuring a periodic structure on a substrate using a scatterometry, the method comprising:

forming a converging illumination having a central axis;

impinging the converging illumination on the periodic structure to generate scattered illumination comprising a plurality of diffraction orders, such that the central axis forms a non-zero incidence angle relative to a horizontal plane defined by an uppermost surface of the substrate, and the central axis forms a non-zero azimuthal angle relative to an orthogonal to the periodic structure;

performing one measurement by collecting only a first diffraction order or both of a zero diffraction order and a first diffraction order from the substrate;

wherein the converging illumination comprises an illumination profile configured to either:

substantially prevent overlap of the diffraction orders while providing multiple angles of incidence on the periodic structure greater than 10 degrees in at least one direction; or

impose discontinuities in a measurement signal described by the scattered illumination as represented in pupil space, the discontinuities enabling the diffraction orders to be distinguished at least at respective locations in the pupil space of a plurality of illumination edges of the illumination profile.

12. A method of characterizing a periodic structure using a scatterometry, the method comprising:

impinging measurement illumination onto the periodic structure, the measurement illumination having a wavelength in the range of 1 nm to 20 nm, to generate scattered illumination comprising a plurality of diffraction orders, while configuring the illumination to converge in incidence and azimuth planes to thereby simultaneously provide a plurality of angles of incidence and a plurality of azimuthal angles; and

sampling an intensity of at least a portion of the scattered illumination;

wherein the measurement illumination comprises an illumination profile configured to either:

substantially prevent overlap of the diffraction orders while providing multiple angles of incidence on the periodic structure greater than 10 degrees in at least one direction; or

impose discontinuities in a measurement signal described by the scattered illumination as represented in pupil space, the discontinuities enabling the diffraction orders to be distinguished at least at respective locations in the pupil space of a plurality of illumination edges of the illumination profile.

13. An apparatus for measuring a substrate comprising at least one periodic structure using scatterometry, the system comprising:

a source for generating measurement illumination having a wavelength in the range of 1 nm to 20 nm;

a substrate support for positioning the substrate;

a focusing optic positioned between the source and the substrate support for focusing the illumination onto the substrate to generate scattered illumination comprising a plurality of diffraction orders,

wherein the measurement illumination simultaneously comprises a plurality of angles of incidence and a plurality of azimuthal angles;

a mask being operable to configure illumination profile of the measurement illumination; and

a detector for collecting at least a portion of the scattered illumination from the substrate.

14. An apparatus according to claim 13, wherein the mask is operable to configure illumination profile of the measurement illumination to either:

substantially prevent overlap of the diffraction orders while providing the plurality of angles of incidence on the periodic structure greater than 10 degrees in at least one direction; or
impose discontinuities in a measurement signal described by the scattered illumination as represented in pupil space, the discontinuities enabling the diffraction orders to be distinguished at least at respective locations in the pupil space of a plurality of illumination edges of the illumination profile.

15. An apparatus according to claim 13 or 14, wherein the measurement illumination comprises a range of angles of incidence that is greater than a range of azimuthal angles.

Fig. 1

Fig. 2

LA

SC1

SC3

CL

0

-1        +1

SC2

MT

Fig. 3

2

4

SM1

PU

Z

X

W

I

6

Z

8

λ

X

Fig. 4

Fig. 5

Fig. 6

Fig. 7

Fig. 8

Fig. 9

Fig. 10

1100

(a)

$1110^{(0,0)}$

$1110^{(0,1)}$

$1110^{(1,0)}$

(b)

$\kappa_y$

$\kappa_x$

$1110^{(0,0)}$

$1110^{(0,1)}$

$1110^{(1,0)}$

(c)

$\kappa_y$

$\kappa_x$

Fig. 11

(a)

1200

$1210^{(0,1)}$

$1210^{(0,0)}$

$1210^{(1,0)}$

(b)

$\kappa_y$

$\kappa_x$

Fig. 12

Fig. 13

Fig. 14

Fig. 15

**EUROPEAN SEARCH REPORT**

Application Number

EP 25 15 0508

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/033193 A1 (VAN DER SCHAAR MAURITS [NL] ET AL) 9 February 2012 (2012-02-09) | 1-4,9-15 | INV. G03F7/00 |
| A | * paragraphs [0002] - [0015], [0033] - [0085]; figures 12, 13 * | 5-8 | G01N21/956 |
| X | WO 2012/062858 A1 (ASML NETHERLANDS BV [NL]; SMILDE HENDRIK [NL] ET AL.) 18 May 2012 (2012-05-18) * paragraphs [0084], [0097]; figures 13a, 13b * | 1 | |
| A | US 2019/293578 A1 (GELLINEAU ANTONIO ARION [US]) 26 September 2019 (2019-09-26) * paragraph [0110]; figures 7a-7D * | 1,10-13 | |

**TECHNICAL FIELDS SEARCHED (IPC)**

G03F

The present search report has been drawn up for all claims

| Place of search | Date of completion of the search | Examiner |
|---|---|---|
| Munich | 11 April 2025 | Apel, Lea |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.................................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 15 0508

This annex lists the patent family members relating to the patent documents cited in the above-mentioned European search report.
The members are as contained in the European Patent Office EDP file on
The European Patent Office is in no way liable for these particulars which are merely given for the purpose of information.

11-04-2025

| Patent document cited in search report | Publication date | Patent family member(s) | Publication date |
|---|---|---|---|
| US 2012033193 A1 | 09-02-2012 | NONE | |
| WO 2012062858 A1 | 18-05-2012 | CN 103201682 A | 10-07-2013 |
| | | JP 5661194 B2 | 28-01-2015 |
| | | JP 2014502420 A | 30-01-2014 |
| | | KR 20130094836 A | 26-08-2013 |
| | | TW 201229496 A | 16-07-2012 |
| | | US 2012123581 A1 | 17-05-2012 |
| | | US 2016033877 A1 | 04-02-2016 |
| | | WO 2012062858 A1 | 18-05-2012 |
| US 2019293578 A1 | 26-09-2019 | CN 111819675 A | 23-10-2020 |
| | | JP 7317849 B2 | 31-07-2023 |
| | | JP 2021518533 A | 02-08-2021 |
| | | KR 20200123848 A | 30-10-2020 |
| | | TW 201945726 A | 01-12-2019 |
| | | US 2019293578 A1 | 26-09-2019 |
| | | WO 2019183011 A1 | 26-09-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1
- US 20230040124 A1
- US 10101675 B2
- US 9134629 B2
- WO 2021121906 A

### Non-patent literature cited in the description

- **LEMAILLET et al.** Intercomparison between optical and X-ray scatterometry measurements of FinFET structures. *Proc. of SPIE*, 2013, 8681